(19) 

Europäisches Patentamt
European Patent Office
Office européen des brevets

(11) **EP 4 318 606 A1**

(12) **EUROPEAN PATENT APPLICATION**
published in accordance with Art. 153(4) EPC

(43) Date of publication:
**07.02.2024 Bulletin 2024/06**

(21) Application number: **22780938.1**

(22) Date of filing: **29.03.2022**

(51) International Patent Classification (IPC):
***H01L 31/052*** *(2014.01)*

(52) Cooperative Patent Classification (CPC):
**H01L 31/052**

(86) International application number:
**PCT/JP2022/015507**

(87) International publication number:
**WO 2022/210727 (06.10.2022 Gazette 2022/40)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **30.03.2021 JP 2021057394**

(71) Applicant: **Idemitsu Kosan Co., Ltd
Tokyo 100-8321 (JP)**

(72) Inventors:
• **HORIGUCHI, Kyohei
Tokyo 100-8321 (JP)**
• **KITAMURA, Yuma
Tokyo 100-8321 (JP)**

(74) Representative: **Hoffmann Eitle
Patent- und Rechtsanwälte PartmbB
Arabellastraße 30
81925 München (DE)**

(54) **PHOTOELECTRIC CONVERSION ELEMENT AND METHOD FOR MANUFACTURING PHOTOELECTRIC CONVERSION ELEMENT**

(57) A photoelectric conversion element includes a photoelectric conversion portion, a first infrared emission layer that is formed on the photoelectric conversion portion and includes a first material selected from one or more of $Y_2O_3$, $HfO_2$, and $ZrO_2$, and a second infrared emission layer that is formed on the first infrared emission layer and includes a second material selected from $SiO_2$ or $Al_2O_3$.

FIG. 1

EP 4 318 606 A1

## Description

Technical Field

The present invention relates to a photoelectric conversion element and a method for manufacturing a photoelectric conversion element.

Background Art

Conventionally, a solar cell, which is one of photoelectric conversion elements, has been used as a power supply means for a satellite or the like operated in outer space. Regarding a solar cell for space use, packaging using a special cover glass and a resin adhesive is generally performed (see, for example, Non Patent Literature 1). In a sealing structure of a solar cell using a special cover glass, the cover glass itself is very expensive, and bonding of the cover glass is complicated, so that the cost is high. Moreover, since the solar cell becomes heavy, there has been room for improvement in suppressing the loading weight at the time of liftoff.
On the other hand, in a solar cell for space use, it has also been proposed to improve infrared emissivity by forming an optical thin film on the surface of the solar cell (see, for example, Patent Literature 1).

Citation List

Non Patent Literature

Non Patent Literature 1: Sumio Matsuda "Coverglasses protected solar cells from cosmic rays" New GLASS Vol. 14, No. 4, 1999, P27-30, the New Glass Forum

Patent Literature

Patent Literature 1: JP 4565105 B2

Summary of Invention

Technical Problem

Since the optical thin film of Patent Literature 1 does not use a cover glass, it is advantageous in terms of cost reduction and loading weight reduction. However, in the optical thin film of Patent Literature 1, the emissivity, which is an important parameter in cooling the solar cell by infrared emission, is only about 75%. Therefore, there has been room for improvement in terms of efficiently cooling the solar cell by infrared emission in outer space.
The present invention has been made in view of the above circumstances, and provides a photoelectric conversion element capable of performing cooling by infrared emission in outer space more efficiently than before.

Solution to Problem

A photoelectric conversion element of an aspect of the present invention includes a photoelectric conversion portion, a first infrared emission layer that is formed on the photoelectric conversion portion and includes a first material selected from one or more of $Y_2O_3$, $HfO_2$, and $ZrO_2$, and a second infrared emission layer that is formed on the first infrared emission layer and includes a second material selected from $SiO_2$ or $Al_2O_3$.

Advantageous Effects of Invention

According to an aspect of the present invention, it is possible to provide a photoelectric conversion element capable of performing cooling by infrared emission in outer space more efficiently than before.

Brief Description of Drawings

Fig. 1 is a thickness direction cross-sectional view illustrating a configuration example of a solar cell of the present embodiment.

Fig. 2 is a thickness direction cross-sectional view illustrating another configuration example of a solar cell of the present embodiment.

Fig. 3 is a diagram illustrating calculation results of emissivity in a CIS-based solar cell in Example 1.

Fig. 4 is a diagram illustrating calculation results of emissivity in a solar cell using a crystalline Si-based semiconductor substrate in Example 1.

Fig. 5 is a diagram illustrating calculation results of emissivity in Example 2.

Fig. 6 is a diagram illustrating calculation results of emissivity in Example 3.

Fig. 7 is a diagram illustrating calculation results of emissivity in Example 4.

Fig. 8 is a diagram illustrating calculation results of emissivity in Example 5.

Fig. 9 is a diagram illustrating a simulation result of Example 7.

Fig. 10 is a diagram illustrating a simulation result of Example 7.

Fig. 11 is a diagram illustrating a simulation result of Example 7.

Description of Embodiments

Hereinafter, an embodiment will be described with reference to the drawings.

In the embodiment, for the sake of easy description thereof, structures or elements other than a main part of the present invention will be described in a simplified or omitted manner. In addition, in the drawings, the same elements are denoted by the same reference numerals. Note that the shapes, dimensions, and the like of the elements in the drawings are schematically illustrated, and do not indicate actual shapes, dimensions, and the like.

The photoelectric conversion element of the present embodiment is attached to a satellite or the like operated in outer space, and is used in an environment exposed to cosmic rays including proton beams. In the present embodiment, a case of a solar cell for space use will be described as an example of the photoelectric conversion element.

First, heat radiation in a solar cell for space use will be outlined.

<Heat radiation of Solar Cell in Outer Space>

In general, a semiconductor such as a solar cell needs to be cooled because performance deterioration and life deterioration occur in a state where high heat is applied. Unlike the ground, there is no atmosphere in space, and solar cells in space are in a vacuum insulation state. Accordingly, since solar cells in space cannot exchange heat with the atmosphere, cooling is performed mainly by infrared emission.

The cooling efficiency by infrared emission is defined by emissivity ε indicated in Formula (1), and the higher the emissivity, the higher the cooling efficiency of the solar cell.

[Math. 1]

$$\varepsilon(T) = \frac{\int_{2.5}^{Y}\{1-R\} \cdot U(\lambda,T)d\lambda}{\int_{2.5}^{Y} U(\lambda,T)d\lambda} \qquad (1)$$

Here, R is the reflectance, U is the radiation intensity of the black body, T is the temperature (K), and λ is the wavelength (gm). Note that since a substrate including a metal film such as a solar cell does not transmit light, the transmittance is set to 0. The emissivity at an arbitrary temperature T can be calculated from Formula (1). In the embodiment and examples, as an example, the emissivity is calculated from room temperature.

The denominator of Formula (1) indicates the radiation intensity of the black body. The numerator of Formula (1) is obtained by multiplying the radiation intensity of the black body by (1-R). Then, the size of the numerator with respect to the denominator of Formula (1) corresponds to the emissivity ε. Accordingly, it can be understood that in order to increase the emissivity ε, it is only required to decrease the reflectance R and increase the value of the numerator of Formula (1).

The range of wavelengths to be integrated is 2.5 um to Y μm, and Y is arbitrarily selected depending on the use environment. In the embodiment and the examples, as an example, the emissivity ε is calculated in a wavelength range from wavelength 2.5 μm to 25 μm. Note that the emissivity may be calculated from a wavelength range from wavelength 2.5 um to 35 um, which is a wider wavelength range.

For example, the reflectance R of the substrate on which a single-layer thin film is formed is calculated as described below from the formula of Fresnel thin film interference.

[Math. 2]

$$R = \left| \frac{r_1 + r_s exp(-i\varphi_1)}{1 + r_1 r_s exp(-i\varphi_1)} \right|^2$$

$$\varphi_1(\lambda, n_1, k_1) = \frac{4\pi d_1}{\lambda}(n_1 - k_1 i)$$

In case of normal incidence, according to Snell's law,

$$r_1(\lambda, n, k) = \frac{N_a - N_1}{N_a + N_1} = \frac{(n_a - n_1) - (k_a - k_1)i}{(n_a + n_1) - (k_a + k_1)i}$$

$$r_s(\lambda, n, k) = \frac{N_1 - N_s}{N_1 + N_s} = \frac{(n_1 - n_s) - (k_1 - k_s)i}{(n_1 + n_s) - (k_1 + k_s)i}$$

Here, $N_a$ is a complex refractive index outside (vacuum) the light receiving surface, $N_\alpha$ is a complex refractive index of a thin film $\alpha$, and $N_s$ is a complex refractive index of the substrate. $d_\alpha$ is the film thickness of the thin film $\alpha$, and $\varphi_\alpha$ is the optical path difference of the thin film $\alpha$. In addition, n is a refractive index (real part of complex refractive index), and k is an extinction coefficient (imaginary part of complex refractive index). Note that when the thin film is a single layer, a variable $\alpha$ is 1.

In addition, for example, the reflectance R of the substrate on which three-layer thin films are formed is calculated by the formula described below. Here, the thin film on the substrate side is referred to as thin film 1 ($\alpha$ = 1), the thin film facing the thin film 1 is referred to as thin film 2 ($\alpha$ = 2), and the thin film on the light receiving surface side facing the thin film 2 is referred to as thin film 3 ($\alpha$ = 3).

[Math. 3]

$$R = \left| \frac{r_3 + \left( \dfrac{r_2 + \left( \dfrac{r_1 + r_s exp(-i\varphi_1)}{1 + r_1 r_s exp(-i\varphi_1)} \right) exp(-i\varphi_2)}{1 + r_2 \left( \dfrac{r_1 + r_s exp(-i\varphi_1)}{1 + r_1 r_s exp(-i\varphi_1)} \right) exp(-i\varphi_2)} \right) exp(-i\varphi_3)}{1 + r_3 \left( \dfrac{r_2 + \left( \dfrac{r_1 + r_s exp(-i\varphi_1)}{1 + r_1 r_s exp(-i\varphi_1)} \right) exp(-i\varphi_2)}{1 + r_2 \left( \dfrac{r_1 + r_s exp(-i\varphi_1)}{1 + r_1 r_s exp(-i\varphi_1)} \right) exp(-i\varphi_2)} \right) exp(-i\varphi_3)} \right|^2$$

According to each of the above formulae, the reflectance R is obtained by the film thickness d of the thin film, and the refractive index n and the extinction coefficient k of the thin film material. In other words, it is possible to obtain a thin film having desired characteristics suitable for heat radiation in a space environment by a combination of the parameters n and k of the thin film material and the film thickness d of the thin film.

<Configuration Example of Solar Cell>

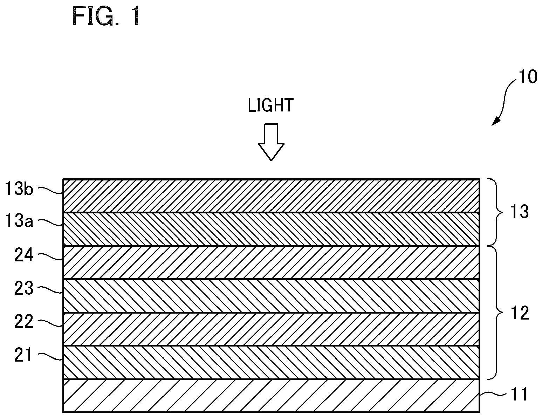

Next, a configuration of a solar cell for space use of the present embodiment will be described with reference to the drawings. Fig. 1 is a thickness direction cross-sectional view illustrating a configuration example of a solar cell of the present embodiment. In the example of Fig. 1, a configuration example of a CIS-based solar cell will be described.

A solar cell 10 has a stacked structure in which a photoelectric conversion portion 12 and an infrared emission layer 13 are sequentially stacked in order from the bottom (substrate side) on a conductive substrate 11. Light such as sunlight enters the photoelectric conversion portion 12 from the side opposite to the conductive substrate 11 side (the upper side in Fig. 1).

(Conductive Substrate 11)

The conductive substrate 11 is formed of, for example, titanium (Ti), stainless steel (SUS), copper, aluminum, an alloy thereof, or the like. The conductive substrate 11 may be a rigid metal substrate or a flexible metal substrate. The conductive substrate 11 may have a stacked structure in which a plurality of metal base materials is stacked, and for example, a stainless foil, a titanium foil, or a molybdenum foil may be formed on the surface of the substrate.

The shape and dimension of the conductive substrate 11 are appropriately determined according to the size and the like of the solar cell 10. The entire shape of the conductive substrate 11 of the present embodiment is, for example, a rectangular flat plate shape, but is not limited thereto.

When a flexible metal substrate is applied as the conductive substrate 11, the solar cell 10 can be bent, and cracking of the substrate due to bending can also be suppressed. Further, in the above case, it is easy to reduce the weight and thickness of the solar cell 10 as compared with a glass substrate and a resin substrate.

Note that, in the solar cell for space use, the conductive substrate 11 is preferably formed of titanium or an alloy containing titanium from the viewpoint of suppressing the loading weight at the time of liftoff and increasing the strength of the solar cell.

(Photoelectric Conversion Portion 12)

The photoelectric conversion portion 12 has a stacked structure in which a first electrode layer 21, a photoelectric conversion layer 22, a buffer layer 23, and a second electrode layer 24 are sequentially stacked in order from the bottom (substrate side).

(First Electrode Layer 21)

The first electrode layer 21 is a metal electrode layer such as of molybdenum (Mo) or the like, and is formed on the conductive substrate 11. The first electrode layer 21 faces not the light receiving surface side but the back surface side (conductive substrate 11 side) of the photoelectric conversion layer 22, and thus is also referred to as a back surface electrode. Although not particularly limited, the thickness of the first electrode layer 21 is, for example, 50 nm to 1000 nm.

(Photoelectric Conversion Layer 22)

The photoelectric conversion layer 22 is formed on the first electrode layer 21. The photoelectric conversion layer 22 may have a double graded structure having a large band gap on the light receiving surface side (upper side in Fig. 1) and the back surface side (lower side in Fig. 1) and a small band gap on the inner side in the thickness direction of the photoelectric conversion layer 22. Although not particularly limited, the thickness of the photoelectric conversion layer 22 is, for example, 1.0 um to 3.0 $\mu$m.

The photoelectric conversion layer 22 functions as a polycrystalline or microcrystalline p-type compound semiconductor layer. The photoelectric conversion layer 22 is, for example, a CIS-based photoelectric conversion element using a group I-III-VI$_2$ compound semiconductor having a chalcopyrite structure containing a group I element, a group III element, and a group VI element (chalcogen element). The group I element can be selected from copper (Cu), silver (Ag), gold (Au), and the like. The group III element can be selected from indium (In), gallium (Ga), aluminum (Al), and the like. In addition, the photoelectric conversion layer 22 may contain tellurium (Te) or the like in addition to selenium (Se) and sulfur (S) as the group VI element. In addition, the photoelectric conversion layer 22 may contain an alkali metal such as Li, Na, K, Rb, or Cs.

(Buffer Layer 23)

The buffer layer 23 is formed on the photoelectric conversion layer 22. Although not particularly limited, the thickness of the buffer layer 23 is, for example, 10 nm to 100 nm.

The buffer layer 23 is, for example, an n-type or i (intrinsic)-type high-resistance conductive layer. Here, the term "high resistance" means having a resistance value higher than the resistance value of the second electrode layer 24 described below.

The buffer layer 23 can be selected from compounds including zinc (Zn), cadmium (Cd), and indium (In). Examples of the compound including zinc include ZnO, ZnS, $Zn(OH)_2$, or Zn(O,S) and Zn(O,S,OH), which are mixed crystals thereof, and further ZnMgO and ZnSnO. Examples of the compound including cadmium include CdS, CdO, or Cd(O,S) and Cd(O,S,OH), which are mixed crystals thereof. Examples of the compound including indium include InS, InO, or In(O,S) and In(O,S,OH), which are mixed crystals thereof, and $In_2O_3$, $In_2S_3$, $In(OH)_x$, and the like can be used. In addition, the buffer layer 23 may have a stacked structure of these compounds.

Note that the buffer layer 23 has an effect of improving characteristics such as photoelectric conversion efficiency, but this may be omitted. When the buffer layer 23 is omitted, the second electrode layer 24 is formed on the photoelectric conversion layer 22.

(Second Electrode Layer 24)

The second electrode layer 24 is formed on the buffer layer 23. The second electrode layer 24 is, for example, an n-type conductive layer. Although not particularly limited, the thickness of the second electrode layer 24 is, for example, 0.5 um to 2.5 um.

The second electrode layer 24 preferably includes, for example, a material having a wide band gap and a sufficiently low resistance value. In addition, since the second electrode layer 24 serves as a path of light such as sunlight, it is preferable to have a property of transmitting light having a wavelength that can be absorbed by the photoelectric conversion layer 22. From this point of view, the second electrode layer 24 is also referred to as a transparent electrode layer or a window layer.

The second electrode layer 24 includes, for example, a metal oxide to which a group III element (B, Al, Ga, or In) is added as a dopant. Examples of the metal oxide include ZnO and $SnO_2$. The second electrode layer 24 can be selected from, for example, $In_2O_3$ (indium oxide), ITO (indium tin oxide), ITiO (indium titanium oxide), IZO (indium zinc oxide), ZTO (zinc tin oxide), FTO (fluorine-doped tin oxide), GZO (gallium-doped zinc oxide), BZO (boron-doped zinc oxide), AZO (aluminum-doped zinc oxide), and the like.

(Infrared Emission Layer 13)

The infrared emission layer 13 is an optical thin film formed on the second electrode layer 24 of the photoelectric conversion portion 12, and has a function of promoting cooling by emission of the solar cell 10. The emissivity of the infrared emission layer 13 of the present embodiment is 0.8 or more, and it is possible to efficiently cool the solar cell 10 by infrared emission as compared with before.

The infrared emission layer 13 includes a first infrared emission layer 13a formed on the second electrode layer 24, and a second infrared emission layer 13b formed on the first infrared emission layer 13a. From the viewpoint of increasing the infrared emissivity of the solar cell 10, it is preferable to stack materials having different refractive indexes and extinction coefficients for the infrared emission layer 13.

The material of the first infrared emission layer 13a is formed of a material selected from one or more of $Y_2O_3$, $HfO_2$, and $ZrO_2$. A film thickness of the first infrared emission layer 13a is set to 110 nm or more and 5000 nm or less. Note that the first infrared emission layer 13a may be a multilayered film in which layers of different materials selected from the above materials are stacked.

Examples of the material of the second infrared emission layer 13b include $SiO_2$ or $Al_2O_3$, which is a material having a high emissivity. The second infrared emission layer 13b may be a single-layer film of either $SiO_2$ or $Al_2O_3$ material, or may be stacked films in which thin films of $SiO_2$ and $Al_2O_3$ are stacked.

The film thickness of the second infrared emission layer 13b is preferably a film thickness of 190 nm or more. In addition, in a case where the second infrared emission layer 13b is stacked films, the film thickness of any one of film included in the stacked films is preferably 150 nm or more.

Note that the thin film stacked on the photoelectric conversion portion 12 ideally has a structure in which the refractive index monotonically increases in the thickness direction from the light receiving surface side to the transparent electrode layer (TCO) over a wide wavelength range from visible light to infrared light. However, in general, in many cases, the change in the refractive index in the thickness direction does not monotonically increase in any wavelength range, and optical design for bringing the optical performance close to desired optical performance over the entire thin film is performed. At this time, by adjusting the optical performance over the entire thin film by using at least one of the first infrared emission layer 13a or the second infrared emission layer 13b as a multilayered film, it is easy to flexibly perform the optical design of the thin film stacked on the photoelectric conversion portion 12.

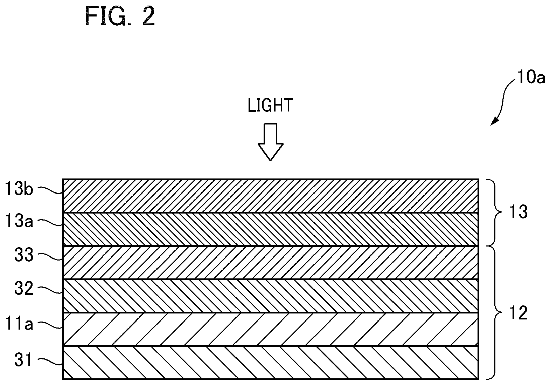

Fig. 2 is a thickness direction cross-sectional view illustrating another configuration example of a solar cell of the present embodiment. In the example of Fig. 2, a configuration example of a solar cell using a crystalline Si-based or GaAs-based semiconductor substrate will be described. Note that, in the example of Fig. 2, the same reference numerals are given to elements common to those in Fig. 1, and redundant description is omitted.

A solar cell 10a illustrated in Fig. 2 has a stacked structure in which a photoelectric conversion portion 12 and an infrared emission layer 13 are sequentially stacked. Light such as sunlight enters the photoelectric conversion portion 12 from the infrared emission layer 13 side (the upper side in Fig. 2).

The photoelectric conversion portion 12 includes a first conductivity type semiconductor substrate 11a, a first electrode layer 31, a second conductivity type semiconductor layer 32, and a second electrode layer 33. Here, the first conductivity type is one of p-type and n-type, and the second conductivity type is the other of p-type and n-type.

The semiconductor substrate 11a is, for example, a silicon substrate made of a first conductivity type single crystal or polycrystal. When the first conductivity type is p-type, for example, the semiconductor substrate 11a is configured to be doped with a small amount of a group III element (for example, boron, aluminum, or the like). When the first conductivity type is n-type, for example, the semiconductor substrate 11a is configured to be doped with a small amount of a group V element (for example, phosphorus, arsenic, or the like).

The first electrode layer 31 is a back surface electrode formed on one surface side (lower side in Fig. 2) of the semiconductor substrate 11a. The first electrode layer 31 includes a thin film of a conductive metal such as silver (Ag), aluminum (Al), or titanium (Ti).

The second conductivity type semiconductor layer 32 is, for example, a layer made of crystalline or polycrystalline silicon of the second conductivity type, and constitutes a pn junction with the first conductivity type semiconductor substrate 11a. The semiconductor layer 32 may be provided on the entire other surface side of the semiconductor substrate 11a, or may be provided on a part of the other surface side of the semiconductor substrate 11a. In addition, when the second conductivity type is n-type, for example, the semiconductor layer 32 is configured to be doped with a small amount of a group V element (for example, phosphorus, arsenic, or the like). When the second conductivity type is p-type, for example, the semiconductor layer 32 is configured to be doped with a small amount of a group III element (for example, boron, aluminum, or the like).

The second electrode layer 33 is formed on the semiconductor layer 32. The second electrode layer 33 is configured as, for example, a transparent electrode layer having translucency or a comb-shaped bus bar electrode.

The infrared emission layer 13 illustrated in Fig. 2 includes a first infrared emission layer 13a formed on the second electrode layer 33, and a second infrared emission layer 13b formed on the first infrared emission layer 13a. The first infrared emission layer 13a and the second infrared emission layer 13b have the same configuration as that of Fig. 1.

<Method for Manufacturing Solar Cell>

Next, a method for manufacturing the solar cell of the above embodiment will be described.

A step of forming the photoelectric conversion portion 12 on the conductive substrate 11 within the solar cell 10 illustrated in Fig. 1 is similar to the step of manufacturing a general CIS-based solar cell. That is, the photoelectric conversion layer 22 is formed by forming a precursor layer on the surface of the conductive substrate 11 on which the first electrode layer 21 is formed and chalcogenizing the precursor layer. Then, the buffer layer 23 and the second electrode layer 24 are sequentially stacked on the photoelectric conversion layer 22 to form the photoelectric conversion portion 12.

On the other hand, in the case of the solar cell 10a illustrated in Fig. 2, the photoelectric conversion portion 12 is formed by forming the first electrode layer 31 on one surface side of the semiconductor substrate 11a and forming the semiconductor layer 32 and the second electrode layer 33 on the other surface side of the semiconductor substrate 11a by a general process of forming a semiconductor layer or an electrode layer.

Next, the first infrared emission layer 13a and the second infrared emission layer 13b are sequentially formed on the second electrode layer 24 (or the second electrode layer 33) of the photoelectric conversion portion 12. The first infrared emission layer 13a and the second infrared emission layer 13b are each formed by using a semiconductor thin film forming process such as a sputtering method, a chemical vapor deposition (CVD) method, a vapor deposition method, a metal organic deposition (Mod) method, or an aerosol deposition (AD) method.

As an example, an example of film formation conditions in a case where a $Y_2O_3$ thin film is formed as the first infrared emission layer 13a and an $Al_2O_3$ thin film and a $SiO_2$ thin film are formed as the second infrared emission layer 13b is indicated in Table 1 below. In the example described below, the thin films of the first infrared emission layer 13a and the second infrared emission layer 13b are formed by electron beam evaporation.

[Table 1]

| Material | Emission (mA) | SWEEP X,Y | rate (nm/s) | Pressure (Pa) |
|---|---|---|---|---|
| $SiO_2$ | 36 | 10 | 0.42 | $2 \times 10^{-3}$ |

(continued)

| Material | Emission (mA) | SWEEP X,Y | rate (nm/s) | Pressure (Pa) |
|---|---|---|---|---|
| $Al_2O_3$ | 95 | 10 | 0.35 | $2 \times 10^{-3}$ |
| $Y_2O_3$ | 120 | 10 | 0.45 | $2 \times 10^{-3}$ |

As described above, in the solar cells 10 and 10a of the present embodiment, the first infrared emission layer 13a including a material selected from one or more of $Y_2O_3$, $HfO_2$, and $ZrO_2$ is formed on the second electrode layer 24 (or the second electrode layer 33) of the photoelectric conversion portion 12. In addition, on the first infrared emission layer 13a, the second infrared emission layer 13b including a material selected from at least one of $SiO_2$ and $Al_2O_3$ is formed.

By stacking the first infrared emission layer 13a and the second infrared emission layer 13b as described above, a high emissivity of 80% or more can be achieved in the solar cell 10, and cooling by infrared emission in outer space can be more efficiently performed than before.

In addition, in the solar cells 10 and 10a of the present embodiment, the first infrared emission layer 13a and the second infrared emission layer 13b are stacked on the photoelectric conversion portion 12 by applying a semiconductor thin film forming process. In the present embodiment, a thin film of an infrared emission layer having high heat radiation can be formed to be lighter than the cover glass, and a complicated assembly step such as bonding of the cover glass can be omitted. Accordingly, the solar cells 10 and 10a of the present embodiment are lightweight and excellent in cost as compared with a solar cell having a cover glass.

<Description of Examples>

Hereinafter, examples of the solar cell of the present embodiment will be described.

(Example 1)

In Example 1, in the solar cell in which the first infrared emission layer and the second infrared emission layer were stacked, a change in emissivity corresponding to the total film thickness was calculated by simulation.

In Example 1, three types of cases (stacked structure of $Y_2O_3/Al_2O_3/SiO_2$, stacked structure of $HfO_2/Al_2O_3/SiO_2$, and stacked structure of $ZrO_2/Al_2O_3/SiO_2$) in which each first infrared emission layer was a thin film of $Y_2O_3$, $HfO_2$, and $ZrO_2$ and the $Al_2O_3$ thin film and the $SiO_2$ thin film were sequentially stacked as the second infrared emission layer were set as simulation targets.

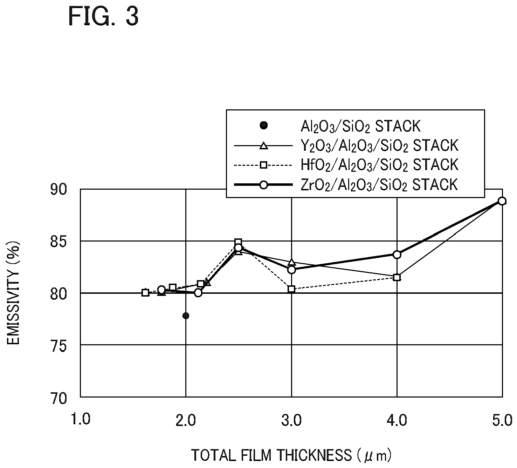

Fig. 3 illustrates calculation results of emissivity in a CIS-based solar cell in Example 1. The vertical axis in Fig. 3 is the emissivity (%) and the horizontal axis in Fig. 3 is the total film thickness ($\mu$m). In addition, Fig. 3 also illustrates the emissivity in the stacked structure of the $Al_2O_3$ thin film and the $SiO_2$ thin film as a comparative example.

As illustrated in Fig. 3, the emissivity of the comparative example (stacked structure of $Al_2O_3/SiO_2$) is less than 0.8 when the total film thickness is 2.0 um. On the other hand, when any one of $Y_2O_3$, $HfO_2$, and $ZrO_2$ was formed as the first infrared emission layer as in Example 1, the emissivity was 0.8 or more at least in a range of the total film thickness of 2.0 um or more. Specifically, it is considered that reflection of light having a wavelength range of 8 $\mu$m to 9 $\mu$m or 12 $\mu$m or more is suppressed by the material of the first infrared emission layer, so that the emissivity is improved as described above. Accordingly, it can be seen that the configuration of the CIS-based solar cell of Example 1 improves the emissivity as compared with the comparative example.

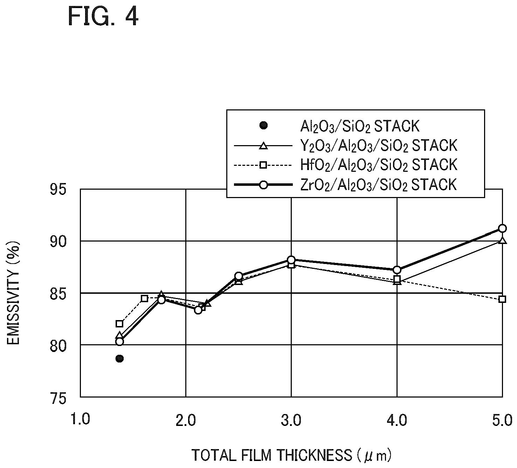

Fig. 4 illustrates calculation results of emissivity in a solar cell using a crystalline Si-based semiconductor substrate in Example 1. The vertical axis in Fig. 4 is the emissivity (%) and the horizontal axis in Fig. 4 is the total film thickness ($\mu$m). In addition, Fig. 4 also illustrates the emissivity in the stacked structure of the $Al_2O_3$ thin film and the $SiO_2$ thin film as a comparative example.

As illustrated in Fig. 4, the emissivity of the comparative example (stacked structure of $Al_2O_3/SiO_2$) is less than 0.8 when the total film thickness is 1.38 $\mu$m. On the other hand, when any one of $Y_2O_3$, $HfO_2$, and $ZrO_2$ was formed as the first infrared emission layer as in Example 1, the emissivity was 0.8 or more at least in a range of the total film thickness of 1.38 $\mu$m or more. Specifically, it is considered that reflection of light having a wavelength range of 8 $\mu$m to 9 $\mu$m or 12 $\mu$m or more is suppressed by the material of the first infrared emission layer, so that the emissivity is improved as described above. Accordingly, it can be seen that the configuration of the solar cell using the crystalline Si-based semiconductor substrate of Example 1 also improves the emissivity as compared with the comparative example as in the case of the CIS-based solar cell illustrated in Fig. 3.

(Example 2)

In Example 2, a change in emissivity according to the film thickness of the first infrared emission layer was calculated by simulation. Note that the configuration from the conductive substrate to the transparent electrode layer of the solar cell of Example 2 is a CIS solar cell.

In Example 2, three types of cases (stacked structure of $Y_2O_3/Al_2O_3/SiO_2$, stacked structure of $HfO_2/Al_2O_3/SiO_2$, and stacked structure of $ZrO_2/Al_2O_3/SiO_2$) similar to those in Example 1 were set as simulation targets. In each case of Example 2, the film thicknesses of the $Al_2O_3$ thin film and the $SiO_2$ thin film, which are the second infrared emission layer, were set to 1 $\mu$m.

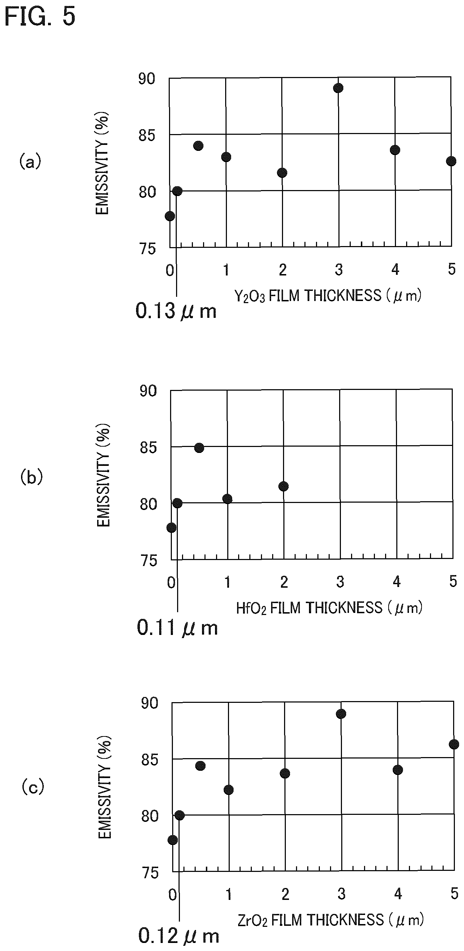

Figs. 5(a) to 5(c) illustrate calculation results of emissivity in Example 2. The vertical axis in each drawing of Fig. 5 is the emissivity (%), and the horizontal axis in each drawing of Fig. 5 is the film thickness ($\mu$m) of the first infrared emission layer.

Fig. 5(a) corresponds to the stacked structure of $Y_2O_3/Al_2O_3/SiO_2$, Fig. 5(b) corresponds to the stacked structure of $HfO_2/Al_2O_3/SiO_2$, and Fig. 5(c) corresponds to the stacked structure of $ZrO_2/Al_2O_3/SiO_2$.

As illustrated in Figs. 5(a) to 5(c), it can be seen that the emissivity is 0.8 or more in a range in which $Y_2O_3$, $HfO_2$, and $ZrO_2$ have a predetermined film thickness or more. Specifically, in the example of Fig. 5(a), the emissivity is 0.8 or more when the film thickness of the $Y_2O_3$ thin film is in a range of 130 nm or more. In the example of Fig. 5(b), the emissivity is 0.8 or more when the film thickness of the $HfO_2$ thin film is in a range of 110 nm or more. In the example of Fig. 5(c), the emissivity is 0.8 or more when the film thickness of the $ZrO_2$ thin film is in a range of 120 nm or more.

From the results of Example 2, it is found that the film thickness of the first infrared emission layer needs to be 110 nm or more in order to achieve an emissivity of 0.8 or more. On the other hand, the upper limit of the film thickness of the first infrared emission layer is preferably set to 5000 nm in consideration of film formation cost. Accordingly, the film thickness range of the first infrared emission layer is 110 nm or more and 5000 nm or less, more preferably 130 nm or more and 5000 nm or less, and still more preferably 500 nm or more and 5000 nm or less.

(Example 3)

In Example 3, a change in emissivity in a case where the first infrared emission layer was a multilayered film was calculated by simulation. Note that the configuration from the conductive substrate to the transparent electrode layer of the solar cell of Example 3 is a CIS solar cell.

In Example 3, $HfO_2$ and $Y_2O_3$ are stacked as the first infrared emission layer. In addition, the second infrared emission layer of Example 3 is an $Al_2O_3$ thin film. That is, in Example 3, the stacked structure of $HfO_2/Y_2O_3/Al_2O_3$ is set as a simulation target. In Example 3, the film thicknesses of the $Y_2O_3$ thin film and the $Al_2O_3$ thin film were set to 1.0 um, and the change in emissivity when the $HfO_2$ thin film was changed was calculated.

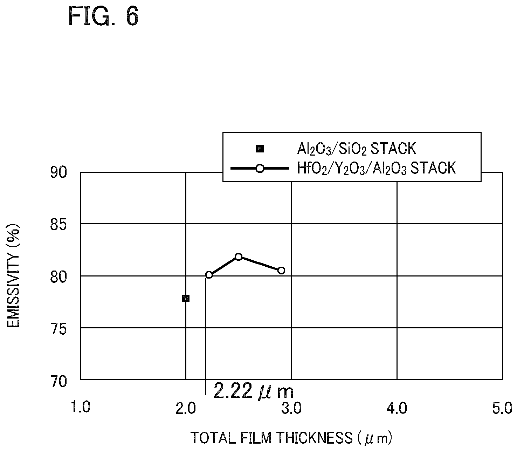

Fig. 6 illustrates calculation results of emissivity in Example 3. The vertical axis in Fig. 6 is the emissivity (%) and the horizontal axis in Fig. 5 is the total film thickness ($\mu$m). In addition, Fig. 6 also illustrates the emissivity in the stacked structure of the $Al_2O_3$ thin film and the $SiO_2$ thin film as a comparative example.

As illustrated in Fig. 6, the emissivity of the comparative example (stacked structure of $Al_2O_3/SiO_2$) is less than 0.8 when the total film thickness is 2.0 $\mu$m. On the other hand, in the configuration of Example 3, the emissivity was 0.8 or more in any of the cases where the total film thickness was 2.22 $\mu$m, 2.5 $\mu$m, and 3.0 $\mu$m. Accordingly, it can be seen that the emissivity can be 0.8 or more even when the first infrared emission layer is a multilayered film.

(Example 4)

In Example 4, when a thin film of any of $Y_2O_3$, $HfO_2$, and $ZrO_2$ was formed as the first infrared emission layer and an $Al_2O_3$ thin film was formed as the second infrared emission layer, the emissivity according to the combination of the film thickness of the first infrared emission layer and the film thickness of the second infrared emission layer was calculated by simulation. Note that the configuration from the conductive substrate to the transparent electrode layer of the solar cell of Example 4 is a CIS solar cell.

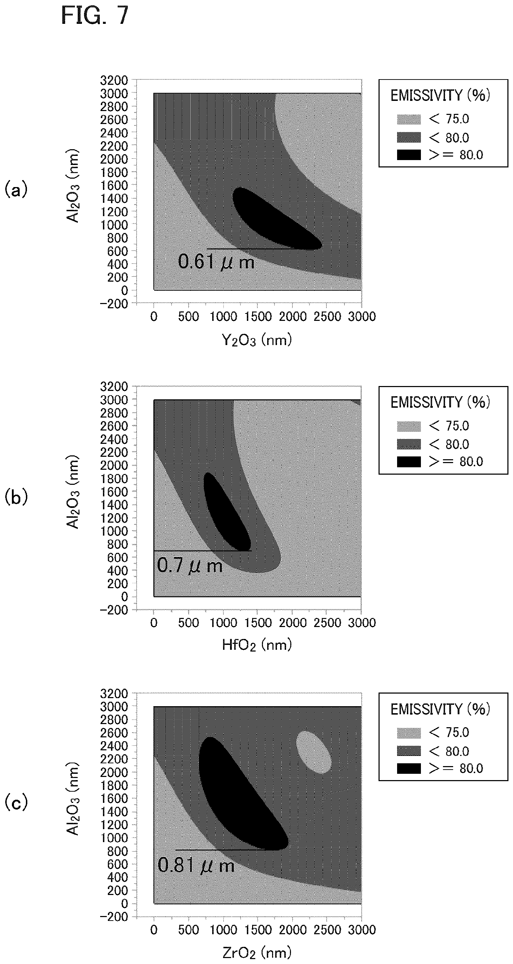

Figs. 7(a) to 7(c) illustrate calculation results of emissivity in Example 4. The vertical axis in each drawing of Fig. 7 is the film thickness ($\mu$m) of the second infrared emission layer, and the horizontal axis in each drawing of Fig. 7 is the film thickness ($\mu$m) of the first infrared emission layer. In addition, in each drawing of Fig. 7, distributions of a region having an emissivity of less than 75%, a region having an emissivity of 75% or more and less than 80%, and a region having an emissivity of 80% or more are illustrated.

In Fig. 7(a), in a case where the first infrared emission layer is a $Y_2O_3$ thin film and the film thickness of the $Al_2O_3$ thin film is 610 nm or more, a region having an emissivity of 80% or more is recognized. In addition, in Example 4, an example of a combination of film thicknesses of $Y_2O_3$ and $Al_2O_3$ when the emissivity is 80% is indicated in Table 2.

[Table 2]

| Point | Y$_2$O$_3$ (nm) | Al$_2$O$_3$ (nm) |
|---|---|---|
| 1 | 1150 | 1360 |
| 2 | 1150 | 1470 |
| 3 | 1180 | 1530 |
| 4 | 1220 | 1550 |
| 5 | 1240 | 1130 |
| 6 | 1320 | 1540 |
| 7 | 1370 | 970 |
| 8 | 1420 | 1490 |
| 9 | 1480 | 870 |
| 10 | 1660 | 760 |
| 11 | 1690 | 1300 |
| 12 | 1910 | 660 |
| 13 | 2080 | 1010 |
| 14 | 2140 | 610 |
| 15 | 2290 | 850 |
| 16 | 2360 | 610 |
| 17 | 2430 | 650 |
| 18 | 2430 | 700 |

In Fig. 7(b), in a case where the first infrared emission layer is an HfO$_3$ thin film and the film thickness of the Al$_2$O$_3$ thin film is 700 nm or more, a region having an emissivity of 80% or more is recognized. In addition, in Example 4, an example of a combination of film thicknesses of HfO$_2$ and Al$_2$O$_3$ when the emissivity is 80% is indicated in Table 3.

[Table 3]

| Point | HfO$_2$ (nm) | Al$_2$O$_3$ (nm) |
|---|---|---|
| 1 | 720 | 1700 |
| 2 | 720 | 1770 |
| 3 | 740 | 1860 |
| 4 | 750 | 1490 |
| 5 | 780 | 1890 |
| 6 | 830 | 1230 |
| 7 | 880 | 1800 |
| 8 | 930 | 1010 |
| 9 | 970 | 1680 |
| 10 | 1010 | 890 |
| 11 | 1140 | 760 |
| 12 | 1250 | 700 |
| 13 | 1350 | 700 |
| 14 | 1350 | 990 |

(continued)

| Point | HfO$_2$ (nm) | Al$_2$O$_3$ (nm) |
|---|---|---|
| 15 | 1400 | 770 |
| 16 | 1400 | 840 |

In Fig. 7(c), in a case where the first infrared emission layer is a ZrO$_2$ thin film and the film thickness of the Al$_2$O$_3$ thin film is 810 nm or more to 2500 nm, a region having an emissivity of 80% or more is recognized. In addition, in Example 4, an example of a combination of film thicknesses of ZrO$_2$ and Al$_2$O$_3$ when the emissivity is 80% is indicated in Table 4.

[Table 4]

| Point | ZrO$_2$ (nm) | Al$_2$O$_3$ (nm) |
|---|---|---|
| 1 | 650 | 2080 |
| 2 | 650 | 2210 |
| 3 | 670 | 2350 |
| 4 | 690 | 1820 |
| 5 | 710 | 2450 |
| 6 | 770 | 2520 |
| 7 | 780 | 1550 |
| 8 | 830 | 2530 |
| 9 | 900 | 1320 |
| 10 | 910 | 2490 |
| 11 | 1000 | 2400 |
| 12 | 1130 | 1060 |
| 13 | 1140 | 2210 |
| 14 | 1280 | 950 |
| 15 | 1340 | 1910 |
| 16 | 1500 | 850 |
| 17 | 1620 | 1500 |
| 18 | 1680 | 810 |
| 19 | 1810 | 810 |
| 20 | 1880 | 1120 |
| 21 | 1900 | 840 |
| 22 | 1920 | 1040 |
| 23 | 1940 | 890 |
| 24 | 1950 | 930 |

(Example 5)

In Example 5, when a thin film of any of Y$_2$O$_3$ and ZrO$_2$ was formed as the first infrared emission layer and an SiO$_2$ thin film was formed as the second infrared emission layer, the emissivity according to the combination of the film thickness of the first infrared emission layer and the film thickness of the second infrared emission layer was calculated by simulation. Note that the configuration from the conductive substrate to the transparent electrode layer of the solar cell of Example 5 is a CIS solar cell.

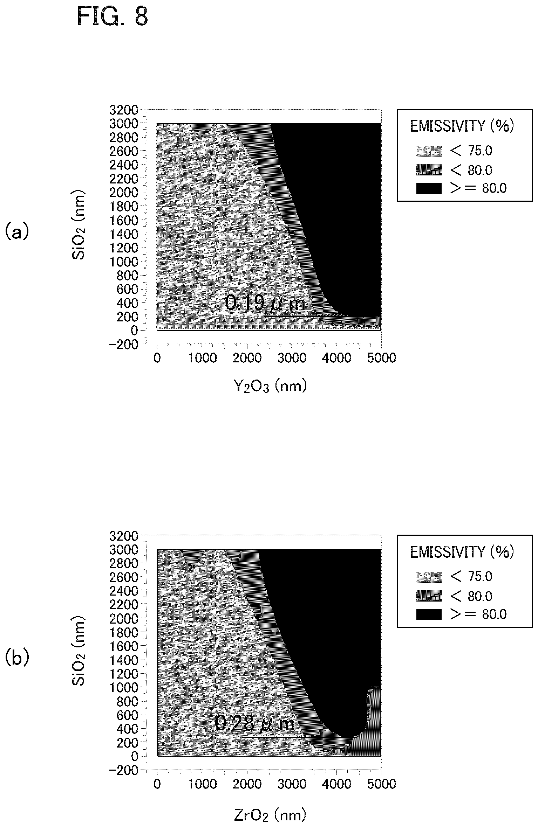

Figs. 8(a) and 8(b) illustrate calculation results of emissivity in Example 5. The vertical axis in each drawing of Fig. 8 is the film thickness ($\mu$m) of the second infrared emission layer, and the horizontal axis in each drawing of Fig. 8 is the film thickness ($\mu$m) of the first infrared emission layer. In addition, in each drawing of Fig. 8, distributions of a region having an emissivity of less than 75%, a region having an emissivity of 75% or more and less than 80%, and a region having an emissivity of 80% or more are illustrated.

In Fig. 8(a), in a case where the first infrared emission layer is a $Y_2O_3$ thin film and the film thickness of the $SiO_2$ thin film is 190 nm or more, a region having an emissivity of 80% or more is recognized. In addition, in Example 5, an example of a combination of film thicknesses of $Y_2O_3$ and $SiO_2$ when the emissivity is 80% is indicated in Table 5.

[Table 5]

| Point | $Y_2O_3$ (nm) | $SiO_2$ (nm) |
|---|---|---|
| 1 | 2550 | 2950 |
| 2 | 2550 | 2990 |
| 3 | 2680 | 2550 |
| 4 | 2880 | 2160 |
| 5 | 3160 | 1660 |
| 6 | 3360 | 1260 |
| 7 | 3550 | 840 |
| 8 | 3690 | 570 |
| 9 | 3850 | 370 |
| 10 | 4030 | 270 |
| 11 | 4270 | 210 |
| 12 | 4500 | 190 |
| 13 | 4930 | 190 |
| 14 | 4990 | 200 |

In Fig. 8(b), in a case where the first infrared emission layer is a $ZrO_2$ thin film and the film thickness of the $SiO_2$ thin film is 280 nm or more, a region having an emissivity of 80% or more is recognized. In addition, in Example 5, an example of a combination of film thicknesses of $ZrO_2$ and $SiO_2$ when the emissivity is 80% is indicated in Table 6.

[Table 6]

| Point | $ZrO_2$ (nm) | $SiO_2$ (nm) |
|---|---|---|
| 1 | 2260 | 2990 |
| 2 | 2340 | 2680 |
| 3 | 2420 | 2460 |
| 4 | 2600 | 2060 |
| 5 | 2890 | 1570 |
| 6 | 3410 | 820 |
| 7 | 3550 | 640 |
| 8 | 3720 | 470 |
| 9 | 3970 | 330 |
| 10 | 4220 | 280 |
| 11 | 4360 | 280 |
| 12 | 4550 | 330 |

(continued)

| Point | ZrO$_2$ (nm) | SiO$_2$ (nm) |
|-------|--------------|--------------|
| 13 | 4660 | 430 |
| 14 | 4680 | 470 |
| 15 | 4690 | 860 |
| 16 | 4720 | 950 |
| 17 | 4790 | 1000 |
| 18 | 4860 | 1010 |
| 19 | 4930 | 1000 |
| 20 | 4990 | 990 |

Accordingly, it can be seen that when the SiO$_2$ thin film is adopted as the second infrared emission layer, the emissivity can be 80% or more in a range of a film thickness of 190 nm or more.

(Example 6)

In Example 6, four solar cells having different thin films formed on a transparent electrode layer were compared, and the difference in emissivity was calculated by simulation. The configuration from the conductive substrate to the transparent electrode layer of the solar cell of Example 6 is a CIS solar cell. The configuration of the solar cell of Example 6 is described below.

- Comparative Example 1: A solar cell without a thin film on a transparent electrode layer
- Comparative Example 2: A solar cell having a Y$_2$O$_3$ thin film of 1.2 um formed on a transparent electrode layer
- Example 6A: A solar cell in which a Y$_2$O$_3$ thin film of 1.2 um and an Al$_2$O$_3$ thin film of 1.4 um are stacked and formed in order from the bottom on a transparent electrode layer
- Example 6B: A solar cell in which a Y$_2$O$_3$ thin film of 1.2 um, an Al$_2$O$_3$ thin film of 0.7 um, and an SiO$_2$ thin film of 0.7 um are stacked and formed in order from the bottom on a transparent electrode layer

The emissivity in Comparative Example 1 is 31.3%, and the emissivity in Comparative Example 2 is 49.0%. On the other hand, the emissivity in Example 6A was 80.1%, and the emissivity in Example 6B was 84.6%. Accordingly, in the configuration in which the second infrared emission layer was stacked on the first infrared emission layer as in Examples 6A and 6B, the emissivity was improved as compared with Comparative Examples 1 and 2, and the emissivity exceeding 80% was obtained.

In addition, it is also found that when the second infrared emission layer has a stacked structure of Al$_2$O$_3$ and SiO$_2$ as in Example 6B, the emissivity is improved as compared with the case where the second infrared emission layer is formed of a single-layer SiO$_2$ thin film as in Example 6A.

(Example 7)

In Example 7, in a case where an Al$_2$O$_3$ thin film and an SiO$_2$ thin film are stacked and formed as the second infrared emission layer on the first infrared emission layer, each film thickness for achieving an emissivity of 80% or more was calculated by simulation. In Example 7, the film thicknesses of the Al$_2$O$_3$ thin film and the SiO$_2$ thin film are calculated in a case where the material of the first infrared emission layer is Y$_2$O$_3$, ZrO$_2$, or HfO$_2$. Note that the configuration from the conductive substrate to the transparent electrode layer of the solar cell of Example 7 is a CIS solar cell.

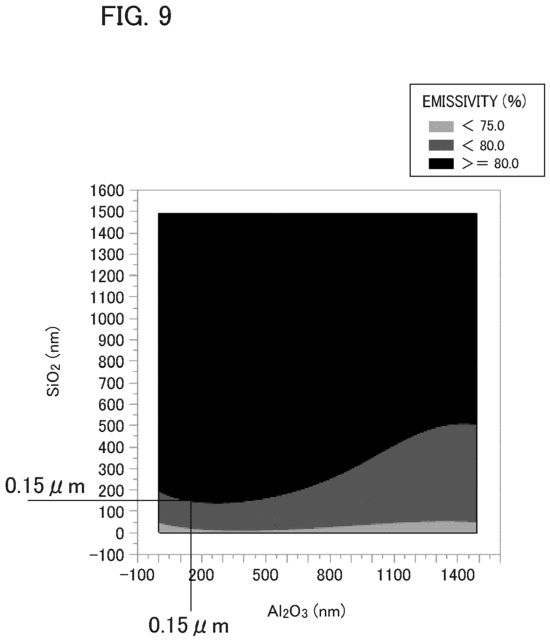

Figs. 9 to 11 illustrate simulation results of Example 7. The vertical axis in each drawing of Figs. 9 to 11 is the film thickness (nm) of the SiO$_2$ thin film, and the horizontal axis in each drawing of Figs. 9 to 11 is the film thickness (nm) of the Al$_2$O$_3$ thin film. In addition, in each drawing of Figs. 9 to 11, distributions of a region having an emissivity of less than 75%, a region having an emissivity of 75% or more and less than 80%, and a region having an emissivity of 80% or more are illustrated.

Fig. 9 is a distribution diagram illustrating the relationship between the film thicknesses of the Al$_2$O$_3$ thin film and the SiO$_2$ thin film when the material of the first infrared emission layer is Y$_2$O$_3$ (film thickness 4.5 $\mu$m). In the case of Fig. 9, when both the film thickness of the Al$_2$O$_3$ thin film and the film thickness of the SiO$_2$ thin film are 0.15 um, a region having an emissivity of 80% or more is recognized. In addition, an example of a combination of film thicknesses of $Al_2O_3$ and $SiO_2$ when the material of the first infrared emission layer is $Y_2O_3$ and the emissivity is 80% in Example 7 is indicated in Table 7.

[Table 7]

| Point | $Al_2O_3$ (nm) | $SiO_2$ (nm) |
|---|---|---|
| 1 | 0 | 190 |
| 2 | 180 | 140 |
| 3 | 380 | 140 |
| 4 | 640 | 190 |
| 5 | 870 | 280 |
| 6 | 1040 | 370 |
| 7 | 1180 | 450 |
| 8 | 1360 | 510 |
| 9 | 1490 | 510 |

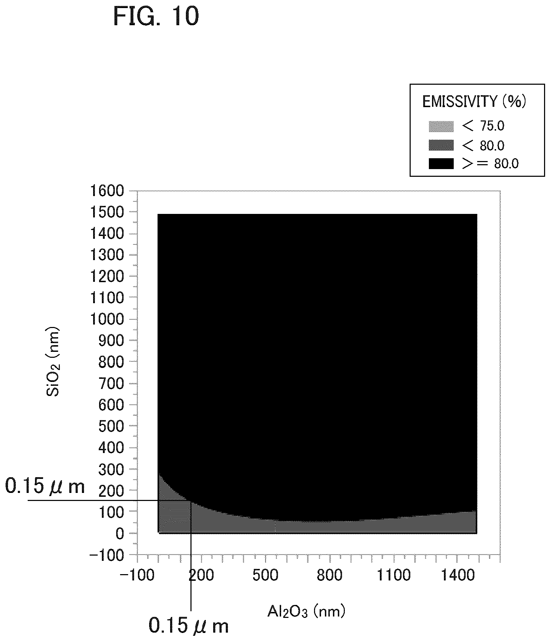

Fig. 10 is a distribution diagram illustrating the relationship between the film thicknesses of the $Al_2O_3$ thin film and the $SiO_2$ thin film when the material of the first infrared emission layer is $ZrO_2$ (film thickness 4.2 um). In the case of Fig. 10, when both the film thickness of the $Al_2O_3$ thin film and the film thickness of the $SiO_2$ thin film are 0.15 $\mu$m, a region having an emissivity of 80% or more is recognized. In addition, an example of a combination of film thicknesses of $Al_2O_3$ and $SiO_2$ when the material of the first infrared emission layer is $ZrO_2$ and the emissivity is 80% in Example 7 is indicated in Table 8.

[Table 8]

| Point | $Al_2O_3$ (nm) | $SiO_2$ (nm) |
|---|---|---|
| 1 | 0 | 290 |
| 2 | 40 | 230 |
| 3 | 110 | 170 |
| 4 | 220 | 120 |
| 5 | 320 | 90 |
| 6 | 430 | 70 |
| 7 | 520 | 60 |
| 8 | 1020 | 60 |
| 9 | 1160 | 80 |
| 10 | 1270 | 90 |
| 11 | 1380 | 100 |
| 12 | 1490 | 100 |

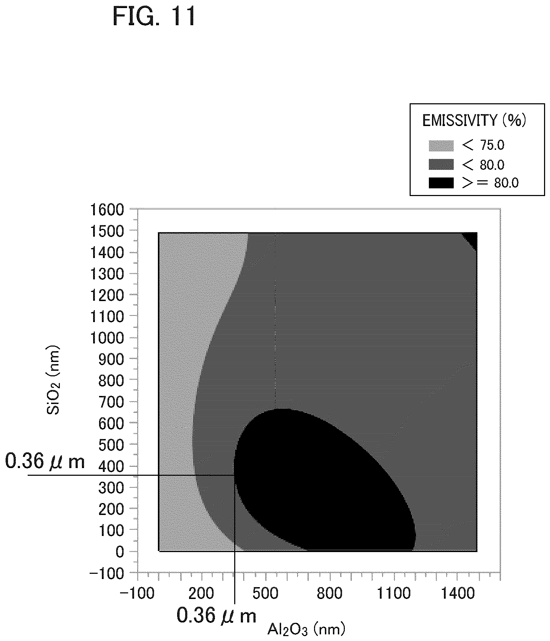

Fig. 11 is a distribution diagram illustrating the relationship between the film thicknesses of the $Al_2O_3$ thin film and the $SiO_2$ thin film when the material of the first infrared emission layer is $HfO_2$ (film thickness 1.25 $\mu$m). In the case of Fig. 11, when both the film thickness of the $Al_2O_3$ thin film and the film thickness of the $SiO_2$ thin film are 0.36 $\mu$m, a region having an emissivity of 80% or more is recognized. In addition, an example of a combination of film thicknesses of $Al_2O_3$ and $SiO_2$ when the material of the first infrared emission layer is $HfO_2$ and the emissivity is 80% in Example 7 is indicated in Table 9.

[Table 9]

| Point | Al$_2$O$_3$ (nm) | SiO$_2$ (nm) |
|---|---|---|
| 1 | 360 | 320 |
| 2 | 360 | 460 |
| 3 | 380 | 520 |
| 4 | 410 | 200 |
| 5 | 410 | 580 |
| 6 | 480 | 120 |
| 7 | 480 | 640 |
| 8 | 540 | 660 |
| 9 | 550 | 70 |
| 10 | 620 | 660 |
| 11 | 670 | 650 |
| 12 | 700 | 0 |
| 13 | 750 | 620 |
| 14 | 870 | 550 |
| 15 | 970 | 470 |
| 16 | 1090 | 340 |
| 17 | 1160 | 230 |
| 18 | 1190 | 0 |
| 19 | 1200 | 30 |
| 20 | 1200 | 120 |

As indicated in Example 6 described above, the emissivity is improved by making the second infrared emission layer have a stacked structure. In a case where the second infrared emission layer has a stacked structure, it is found that it is necessary to set the film thickness of at least one of the Al$_2$O$_3$ thin film and the SiO$_2$ thin film to 150 nm or more in order to achieve an emissivity of 80% or more as illustrated in Figs. 9 to 11.

<Supplementary Matters of the Embodiment>

In the above embodiment, the configuration examples of the solar cell including the first infrared emission layer and the second infrared emission layer have been described as an example of the photoelectric conversion element for space use. However, the configuration of the photoelectric conversion element of the present invention is not limited to a solar cell, and can be widely applied to other semiconductor elements (for example, an imaging element or the like) that are used in outer space and include a photoelectric conversion layer.

In addition, the present invention is not limited to a CIS-based solar cell or a solar cell using a crystalline Si-based semiconductor substrate, and can also be applied to a compound-based solar cell other than a CIS-based solar cell or another general solar cell. As an example, the configuration of the present invention can also be applied to a compound-based solar cell such as a CZTS-based solar cell, a CIGS-based solar cell, a CdTe-based solar cell, or a GaAs-based solar cell, an organic solar cell, or the like.

In addition, the first infrared emission layer or the second infrared emission layer of the present invention may be configured as stacked films of three or more layers.

As described above, the embodiment of the present invention has been described, but the embodiment is presented as an example, and is not intended to limit the scope of the present invention. The embodiment can be implemented in various forms other than the above, and various omissions, substitutions, changes, and the like can be made without departing from the gist of the present invention. The embodiment and modifications thereof are included in the scope and gist of the present invention, and the invention described in the claims and equivalents thereof are also included in the scope and gist of the present invention.

The present application claims priority based on Japanese Patent Application No. 2021-057394 filed on March 30, 2021, and the entire contents of Japanese Patent Application No. 2021-057394 are incorporated herein by reference.

Reference Signs List

| 10, 10a | Solar cell |
| 11 | Conductive substrate |
| 11a | Semiconductor substrate |
| 12 | Photoelectric conversion portion |
| 13 | Infrared emission layer |
| 13a | First infrared emission layer |
| 13b | Second infrared emission layer |
| 21 | First electrode layer |
| 22 | Photoelectric conversion layer |
| 23 | Buffer layer |
| 24 | Second electrode layer |
| 31 | First electrode layer |
| 32 | Semiconductor layer |
| 33 | Second electrode layer |

**Claims**

1. A photoelectric conversion element comprising:

   a photoelectric conversion portion;
   a first infrared emission layer that is formed on the photoelectric conversion portion and includes a first material selected from one or more of $Y_2O_3$, $HfO_2$, and $ZrO_2$; and
   a second infrared emission layer that is formed on the first infrared emission layer and includes a second material selected from at least one of $SiO_2$ and $Al_2O_3$.

2. The photoelectric conversion element according to claim 1, wherein the photoelectric conversion portion is formed on a substrate.

3. The photoelectric conversion element according to claim 1, wherein the photoelectric conversion portion includes a semiconductor substrate.

4. The photoelectric conversion element according to any one of claims 1 to 3, wherein the first infrared emission layer has a thickness of 110 nm or more and 5000 nm or less.

5. The photoelectric conversion element according to any one of claims 1 to 3, wherein the first infrared emission layer is stacked films in which two or more types of the first material are stacked.

6. The photoelectric conversion element according to any one of claims 1 to 3, wherein the second infrared emission layer has a thickness of 190 nm or more.

7. The photoelectric conversion element according to any one of claims 1 to 3, wherein the second infrared emission layer is stacked films in which layers including two types of the second material are stacked.

8. The photoelectric conversion element according to claim 7, wherein a thickness of any one of film in the stacked films of the second infrared emission layer is 150 nm or more.

9. A method for manufacturing a photoelectric conversion element, the method comprising:

   a step of forming a photoelectric conversion portion;
   a step of forming a first infrared emission layer on the photoelectric conversion portion using a first material selected from one or more of $Y_2O_3$, $HfO_2$, and $ZrO_2$; and
a step of forming a second infrared emission layer on the first infrared emission layer using a second material selected from at least one of $SiO_2$ and $Al_2O_3$.

FIG. 1

LIGHT

10

13b — 13
13a —

24 —
23 —
22 —
21 —

12

11

FIG. 2

LIGHT

⇩

FIG. 3

FIG. 4

## FIG. 5

(a)

0.13 μm

(b)

0.11 μm

(c)

0.12 μm

# FIG. 6

## FIG. 7

(a)

(b)

(c)

# FIG. 8

(a)

(b)

FIG. 9

## FIG. 10

## FIG. 11

**INTERNATIONAL SEARCH REPORT**

| International application No. |
| --- |
| **PCT/JP2022/015507** |

| A. | CLASSIFICATION OF SUBJECT MATTER |
| --- | --- |

*H01L 31/052*(2014.01)i
FI: H01L31/04 600

According to International Patent Classification (IPC) or to both national classification and IPC

| B. | FIELDS SEARCHED |
| --- | --- |

Minimum documentation searched (classification system followed by classification symbols)

H01L31/00-31/072; H01L31/18-31/20; H01L51/42-51/48; H02S10/00-10/40; H02S30/00-99/00

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| X | JP 2009-520360 A (THE BOEING COMPANY) 21 May 2009 (2009-05-21) | 1-4, 6-9 |
| | paragraphs [0003]-[0005], [0008], [0012], [0020]-[0025], fig. 2, 6-7 | |
| Y | | 5 |
| X | CN 112490297 A (CHINA ELECTRONIC TECHNOLOGY GROUP CORPORATION NO.18 RESEARCH INSTITUTE) 12 March 2021 (2021-03-12) | 1, 9 |
| | paragraphs [0028]-[0029], [0032], fig. 2 | |
| A | | 2-8 |
| Y | WO 2017/111030 A1 (MITSUBISHI CHEM CORP) 29 June 2017 (2017-06-29) | 5 |
| | paragraphs [0012], [0019]-[0020], fig. 1 | |
| A | JP 2006-310711 A (JAPAN AEROSPACE EXPLORATION AGENCY) 09 November 2006 (2006-11-09) | 1-9 |
| | paragraphs [0005], [0017]-[0018], fig. 2 | |
| A | JP 2018-18894 A (KYOCERA CORP) 01 February 2018 (2018-02-01) | 1-9 |
| | entire text, all drawings | |

| ☑ Further documents are listed in the continuation of Box C. | ☑ See patent family annex. |
| --- | --- |

| * | Special categories of cited documents: |
| --- | --- |
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **15 April 2022** | **10 May 2022** |

| Name and mailing address of the ISA/JP | Authorized officer |
| --- | --- |
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

**INTERNATIONAL SEARCH REPORT**

International application No.

**PCT/JP2022/015507**

**C.    DOCUMENTS CONSIDERED TO BE RELEVANT**

| Category* | Citation of document, with indication, where appropriate, of the relevant passages | Relevant to claim No. |
|---|---|---|
| A | JP 7-58355 A (OPTICAL COATING LABORATORY INC) 03 March 1995 (1995-03-03) <br> entire text, all drawings | 1-9 |
| A | JP 2021-502703 A (THE REGENTS OF THE UNIVERSITY OF MICIGAN) 28 January 2021 (2021-01-28) <br> entire text, all drawings | 1-9 |
| P, A | CN 113257925 A (HANGZHOU DIANZI UNIVERSITY) 13 August 2021 (2021-08-13) <br> paragraphs [0008], [0018]-[0019], [0026], [0040], fig. 1 | 1-9 |

Form PCT/ISA/210 (second sheet) (January 2015)

**INTERNATIONAL SEARCH REPORT**
**Information on patent family members**

International application No.

**PCT/JP2022/015507**

| Patent document cited in search report | | | Publication date (day/month/year) | Patent family member(s) | Publication date (day/month/year) |
|---|---|---|---|---|---|
| JP | 2009-520360 | A | 21 May 2009 | US 2007/0137694 A1 paragraphs [0004]-[0006], [0009], [0024], [0031]-[0036], fig. 2, 6-7 | |
| CN | 112490297 | A | 12 March 2021 | (Family: none) | |
| WO | 2017/111030 | A1 | 29 June 2017 | (Family: none) | |
| JP | 2006-310711 | A | 09 November 2006 | US 2006/0243320 A1 paragraphs [0008], [0035]-[0036], fig. 2 | |
| JP | 2018-18894 | A | 01 February 2018 | (Family: none) | |
| JP | 7-58355 | A | 03 March 1995 | US 5449413 A entire text, all drawings | |
| JP | 2021-502703 | A | 28 January 2021 | US 2020/0365751 A1 entire text, all drawings CN 111742415 A | |
| CN | 113257925 | A | 13 August 2021 | (Family: none) | |

Form PCT/ISA/210 (patent family annex) (January 2015)

**EP 4 318 606 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 4565105 B

- JP 2021057394 A

**Non-patent literature cited in the description**

- **SUMIO MATSUDA.** Coverglasses protected solar cells from cosmic rays. *New GLASS,* 1999, vol. 14 (4), 27-30